**Europäisches Patentamt**

**European Patent Office**

**Office européen des brevets**

(19)

(11) Veröffentlichungsnummer: **0 053 675**
**B1**

(12) # EUROPÄISCHE PATENTSCHRIFT

(45) Veröffentlichungstag der Patentschrift:
01.08.84

(51) Int. Cl.³: **H 03 H 7/48**

(21) Anmeldenummer: **81108288.2**

(22) Anmeldetag: **13.10.81**

(54) Mehrfachabzweiger für Hochfrequenzenergie mit Rückkanal.

(30) Priorität: **04.12.80 DE 3045800**

(43) Veröffentlichungstag der Anmeldung:
**16.06.82 Patentblatt 82/24**

(45) Bekanntmachung des Hinweises auf die Patenterteilung:
**01.08.84 Patentblatt 84/31**

(84) Benannte Vertragsstaaten:
**AT NL**

(56) Entgegenhaltungen:
**DE - A - 2 047 001**
**US - A - 4 156 212**

**IBM TECHNICAL DISCLOSURE BULLETIN, Band 18, Nr. 9. Februar 1976, Seiten 3139-3140 New York, U.S.A. P.E. STUCKERT: "Broadband directional (bridged-T) signal generator"**
**1972 WESCON TECHNICAL PAPERS, Band 16, Papers presented at the Western Electronic Show and Convention in Los Angeles 19th-22nd September 1972 California, U.S.A. T. NAMEKAWA et al.: "Two-way information distribution system for local community", Session 28/4, Seiten 1-6**

(73) Patentinhaber: **SIEMENS AKTIENGESELLSCHAFT, Berlin und München Wittelsbacherplatz 2, D-8000 München 2 (DE)**

(72) Erfinder: **Langguth, Werner, Ing. grad., Brahmsstrasse 10, D-8033 Krailling (DE)**

## Beschreibung

Die Erfindung bezieht sich auf einen Mehrfachabzweiger für Hochfrequenzenergie mit Rückkanal, insbesondere zur Leistungsaufteilung auf mehrere Verbraucher in Gemeinschaftsantennen- oder Kabelfernsehanlagen, mit mehreren ggf. unter Zwischenschaltung von Leitungsstücken in Kette geschalteten und insgesamt mit einem Wellenwiderstand abgeschlossenen Richtungskopplern, deren Koppelschleifen jeweils an einem Ende mit einem Anschluss versehen und am anderen Ende mit ihrem Wellenwiderstand abgeschlossen sind.

Ein derartiger Mehrfachabzweiger in Form einer gedruckten Schaltung ist aus dem DE-GM 7 505 540 bekannt.

In der Broschüre «Kabelfernsehen», Anlageband 5 zum Telekommunikationsbericht der Kommision für den Ausbau des technischen Kommunikationssystems, 1976, Verlag Dr. Hans Heger, Bonn-Bad Godesberg, insbesondere Seiten 106 bis 139 sind Möglichkeiten von Kabelfernsehanlagen mit Rückkanal beschrieben. Es ist an Kommunikationsformen wie Fernsehen, Tonrundfunk, Text- und Bildverteilung, Warndienste, Teilnehmersignale, Fernmessen, Überwachung, lokale Programme, Auftragsdienst, Informationsdienste, Bibliotheksdienste, interaktive Dienste, Bestandsführung und Datenverarbeitung gedacht, wobei die hin- bzw. rücklaufenden Informationen über entsprechende Frequenzweichen (Hoch- bzw. Tiefpässe) voneinander getrennt werden.

Der Erfindung liegt die Aufgabe zugrunde, einen Mehrfachabzweiger zu realisieren, dessen Anschlüsse zugleich als Eingänge für einen Rückkanal zu einer Zentrale dienen können. Das Frequenzband des Rückkanals liegt dabei unterhalb des Frequenzbandes der zu empfangenden Signale.

Ausgehend von einem Mehrfachabzweiger der einleitend geschilderten Art wird diese Aufgabe erfindungsgemäss dadurch gelöst, dass ein Widerstandsstern vorgesehen ist, dessen Eingänge mit den Koppelschleifen der Richtungskoppler galvanisch und dessen Ausgang mit dem Durchgangsleiter der Kettenschaltung über eine Frequenzweiche verbunden sind.

Die Anschlüsse des Mehrfachabzweigers können so zugleich als Anschlüsse für einen Rückkanal dienen.

Vorteilhaft ist es, wenn dem Ausgang des Widerstandsterns ein Kondensator parallelgeschaltet ist, dass zu jedem Widerstand eine Spule in Reihe geschaltet ist und dass der Kondensator mit jeder Spule einen Tiefpass bildet.

Vorteilhaft ist es weiter, wenn die Frequenzweiche am Ende der Kettenschaltung aber vor dem abschliessenden Wellenwiderstand angeordnet ist. Die Durchgangsdämpfung der Frequenzweiche wirkt sich dann nicht auf die Anschlussdämpfung der Richtungskoppler aus. Ausserdem wird die Richtdämpfung nicht beeinflusst.

Für die Richtdämpfung der Richtungskoppler ist es ferner von Vorteil, wenn die Eingänge des Widerstandsterns mit den Koppelschleifen an den Enden galvanisch verbunden sind, an denen die Anschlüsse angeordnet sind.

Die Anschlussdämpfung wird vermindert, wenn zwischen der Frequenzweiche und dem Kondensator einerseits und den Widerständen und den Spulen andererseits ein Übertrager wie ein Sparübertrager vorgesehen ist.

Die Leitungen und Koppelschleifen des Mehrfachabzweigers können als gedrukte Schaltungen und die Widerstände und der Kondensator als Schichtschaltung ausgebildet sein.

Anhand eines Ausführungsbeispiels wird die Erfindung nachstehend näher erläutert.

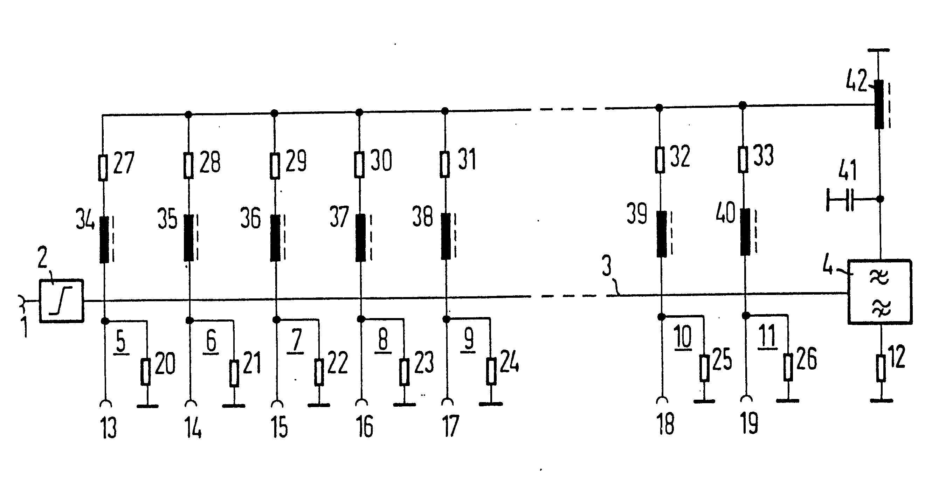

In der Figur bedeuten 1 einen ersten Anschluss, 2 einen Entzerrer, 3 eine Durchgangsleitung, 4 eine Frequenzweiche, 5 bis 11 Richtungskoppler, 12 einen Abschlusswiderstand der Durchgangsleitung 3, 13 bis 19 weitere Anschlüsse, 20 bis 26 Abschlusswiderstände der Koppelschleifen, 27 bis 33 Entkopplungswiderstände, 34 bis 40 Spulen, 41 einen Kondensator und 42 einen Anpassungsübertrager.

Über den ersten Anschluss 1 und den Entzerrer 2 gelangt Hochfrequenzenergie eines Frequenzbandes von 40 bis 862 MHz auf die Durchgangsleitung 3 und über die Frequenzweiche 4 auf den Abschlusswiderstand 12 mit dem Wert des Wellenwiderstandes. Über die Richtungskoppler 5 bis 11 wird Hochfrequenzenergie ausgekoppelt, die um die Koppeldämpfung vermindert an die weiteren Anschlüsse 13 bis 19 gelangt.

In diese weiteren Anschlüsse 13 bis 19 können andererseits Rückkanalsignale eingespeist werden, die über die Spulen 34 bis 40, über die Widerstände 27 bis 33, über den Übertrager 42, über die Frequenzweiche 4, über den Durchgangsleiter 3 und über den Entzerrer 2 zum ersten Anschluss 1 fliessen können.

Die Widerstände 12 und 20 bis 26 haben einen Wert von 75 Ohm und die Widerstände 27 bis 33 einen Widerstandswert von 180 Ohm. Letzterer wurde derart gewählt, dass zwischen je zwei der weiteren Anschlüsse 13 bis 19 eine Entkopplung von 40 dB wirksam ist und ausserdem eine hinreichende Anpassung an den Anschlüssen gegeben ist.

Jede der Spulen 34 bis 40 weist eine Induktivität von 1,5 $\mu$H auf und bildet mit dem Kondensator 41 mit einem Wert von 100 pF einen Tiefpass, der ein Eindringen von Hochfrequenzenergie einer Frequenz < 40 MHz in den Widerstandsstern verhindert.

Das Übertragungsverhältnis des Übertragers 42 ist mit 2 : 1 gewählt.

## Patentansprüche

1. Mehrfachabzweiger für Hochfrequenzenergie mit Rückkanal, insbesondere zur Leistungsaufteilung auf mehrere Verbraucher in Gemeinschaftsantennen- oder Kabelfernsehanlagen, mit mehreren ggf. unter Zwischenschaltung von Leitungsstücken in Kette geschalteten und insgesamt mit einem Wellenwiderstand abgeschlossenen Richtungskopplern, deren Koppelschleifen jeweils an einem Ende mit einem Anschluss versehen und am anderen Ende mit ihrem Wellenwiderstand abgeschlossen sind, dadurch gekennzeichnet, dass für den Rückkanal ein Widerstandsstern (27-33) vorgesehen ist, dessen Eingänge mit den Koppelschleifen der Richtungskoppler (5-11) glavanisch und dessen Ausgang mit dem Durchgangsleiter (3) der Kettenschaltung (5-11) über eine Frequenzweiche (4) verbunden sind.

2. Mehrfachabzweiger nach Anspruch 1, dadurch gekennzeichnet, dass dem Ausgang des Widerstandssterns ein Kondensator (41) parallelgeschaltet ist, dass in Reihe zu jedem Widerstand (27 bis 33) eine Spule (34-40) geschaltet ist und dass der Kondensator (41) mit jeder Spule (34-40) einen Tiefpass bildet.

3. Mehrfachabzweiger nach Anspruch 1 oder 2, dadurch gekennzeichnet, dass die Frequenzweiche (4) am Ende der Kettenschaltung (5-11) angeordnet ist.

4. Mehrfachabzweiger nach Anspruch 1 oder 2, dadurch gekennzeichnet, dass die Eingänge des Widerstandsverteilers mit den Koppelschleifen an den Enden galvanisch verbunden sind, an denen die Anschlüsse (13-19) angeordnet sind.

5. Mehrfachabzweiger nach einem der vorhergehenden Ansprüche, dadurch gekennzeichnet, dass im Widerstandsstern zwischen der Frequenzweiche (4) und dem Kondensator (41) einerseits und den Widerständen (27-33) und den Spulen (34-40) andererseits ein Übertrager (42) angeordnet ist.

6. Mehrfachabzweiger nach Anspruch 5, dadurch gekennzeichnet, dass als Übertrager (42) ein Sparübertrager vorgesehen ist.

7. Mehrfachabzweiger nach einem der vorhergehenden Ansprüche, dadurch gekennzeichnet, dass die Richtungskoppler (5-11) und Leitungsstücke als gedruckte Schaltung ausgebildet sind.

8. Mehrfachabzweiger nach Anspruch 7, dadurch gekennzeichnet, dass die Widerstände (12, 20-33) und der Kondensator (41) als Schichtschaltung ausgebildet sind.

## Claims

1. A multiple coupler for high-frequency energy with a return channel, in particular for power distribution to a plurality of consumers in communal antenna or cable television systems, comprising a plurality of directional couplers connected in a chain, if necessary by interpolating line pieces, and terminated overall by a surge impedance, the coupling loops of which directional couplers are respectively provided with a port at the one end and are terminated by their surge impedance at the other end, characterised in that for the return channel there is provided a impedance star (27-33), whose inputs are d.c. connected to the coupling loops of the directional couplers (5 to 11) and whose output is connected to the through conductor (3) of the chain circuit (5-11) by means of a frequency filter (4).

2. A multiple coupler as claimed in claim 1, characterised in that a capacitor (41) is connected parallel to the output of the impedance star, that each impedance (27-33) is connected in series with a coil (34-40) and that the capacitor (41) together with each coil (34-40) forms a low-pass filter.

3. A multiple coupler as claimed in claim 1 or 2, characterised in that the frequency filter (4) is arranged at the end of the chain circuit (5-11).

4. A multiple coupler as claimed in claim 1 or 2, characterised in that the inputs of the impedance distributor are d.c. connected to the coupling loops at the ends, at which the ports (13-19) are arranged.

5. A multiple coupler as claimed in one of the preceding claims, characterised in that in the impedance star a transformer (42) is arranged between the frequency filter (4) and the capacitor (41) on one hand and the impedance (27-33) and the coils (34-40) on the other hand.

6. A multiple coupler as claimed in claim 5, characterised in that the transformer is an autotransformer (42).

7. A multiple coupler as claimed in one of the preceding claims, characterised in that the directional couplers (5-11) and the line sections are designed as a printed circuit.

8. A multiple coupler as claimed in claim 7, characterised in that the impedances (12, 20-33) and the capacitor (41) are designed as a film circuit.

## Revendications

1. Coupleur multiple pour énergie à haute fréquence avec canal de retour, notamment pour la distribution de puissance à plusieurs appareils d'utilisation dans des installations d'antennes collectives ou de télévision par câble, comportant plusieurs coupleurs directionnels branchés selon un montage itératif, éventuellement moyennant le branchement intercalé d'éléments de lignes, et fermés globalement par une impédance caractéristique et dont les boucles de couplage comportent respectivement une borne à l'une de leurs extrémités et sont fermées sur leur autre extrémité par leur impédance caractéristique, caractérisé par le fait qu'il est prévu, pour le canal de retour, un montage étoile de résistances (27-33) dont les entrées sont reliées galvaniquement aux boucles de couplage des coupleurs directionnels (5-11) et dont la sortie est reliée au conducteur de transit (3) du circuit itérativ (5-11) par l'intermédiaire d'un filtre d'aiguillage (4).

2. Coupleur multiple selon la revendication 1, caractérisé par le fait qu'un condensateur (41) est branché en parallèle sur la sortie du montage étoile des résistances, qu'une bobine (34-40) est branchée en série avec chaque résistance (27-33) et que le condensateur (41) forme avec chaque bobine (34-40) un filtre passe-bas.

3. Coupleur multiple selon les revendications 1 ou 2, caractérisé par le fait que le filtre d'aiguillage (4) est monté à l'extrémité du circuit itératif (5-11).

4. Coupleur multiple suivant la revendication 1 ou 2, caractérisé par le fait que les entrées du répartiteur à résistances sont reliées galvaniquement aux extrémités des boucles de couplage, sur lesquelles sont disposées les bornes (13-19).

5. Coupleur multiple suivant l'une des revendications précédentes, caractérisé par le fait qu'un transformateur (42) est disposé dans le montage étoile de résistances entre le filtre d'aiguillage (4) et le condensateur (41) d'une part et entre les résistances (27-33) et les bobines (34-40) d'autre part.

6. Coupleur multiple suivant la revendication 5, caractérisé par le fait qu'un auto-transformateur est prévu comme transformateur (42).

7. Coupleur multiple suivant l'une des revendications précédentes, caractérisé par le fait que les coupleurs directionnels (5-11) et les éléments de lignes sont réalisés sous la forme de circuits imprimés.

8. Coupleur multiple suivant la revendication 7, caractérisé par le fait que les résistances (12, 20-33) et le condensateur (41) sont réalisés sous la forme d'un circuit à couche.

4